# EUROPEAN PATENT APPLICATION

(11) **EP 3 544 394 A1**
(43) Date of publication of application: **25.09.2019**
(21) Application number: 18163816.4
(22) Date of filing: 24.03.2018
(51) Int. Cl.: H05K 3/30, H05K 3/34, H01L 23/495

(54) **INTEGRATED CIRCUIT LEAD FRAME DESIGN AND METHOD**

(71) Applicant: Melexis Technologies SA, 2022 Bevaix (CH)
(72) Inventor: CHEN, Jian, 2220 Heist-op-den-Berg (BE); GUEORGUIEV SARADJOV, Orlin, 1505 Sofia (BG)
(74) Representative: LC Patents

(57) **Abstract**

A component 10 comprises a housing 12 and a circuit 18 disposed in the housing. One or more leads 14 each have an exterior portion 15 extending from the housing. At least two alignment holes 16 are disposed in the extended portion of one or more of the leads. Each alignment hole is configured to receive a positioning pin. A support has a receiving zone and one or more positioning pins disposed on and protruding from the support in the receiving zone. A component is disposed on or over the support within the receiving zone. A positioning pin is disposed within each of at least two alignment holes. After the positioning pin is disposed within the alignment hole, it can be deformed so that a portion of the positioning pin is disposed over an electrically conductive portion of the lead that is not the alignment hole to control the location of the housing over the support.

## Description

### FIELD OF THE INVENTION

The present invention relates to accurate positioning of an electronic component on a support.

### BACKGROUND OF THE INVENTION

Sensors are widely used in electronic devices to measure attributes of the environment and report a measured signal value. In many applications, the exact location of the sensor within the sensor system is an important element of the overall sensor system.

Some conventional electronic devices assembled on printed circuit boards comprise leads (electrical connection pins) extending from a device housing. An electronic circuit, for example an integrated circuit, is disposed in the housing and conventionally adhered to a lead frame with leads extending through the housing to provide electrical connections exterior to the housing to the integrated circuit within the housing. Contacts on the integrated circuit die are electrically connected to the leads with wire bonds inside the housing. The exterior portion of the leads extending from the housing can be inserted into holes in the printed circuit board or in a socket with socket pins inserted into holes in the printed circuit board. For example, dual inline packages (DIPs) and sockets having two rows of connection pins are commonly used, as described in U.S. Patent No. 4,540,226.

Printed circuit boards frequently include connectors soldered into holes to provide access to the devices on the printed circuit boards (see, for example U.S. Patent No. 8,480,411). In other applications, multiple boards, for example daughter cards are sometimes stacked together, for example as disclosed in U.S. Patent Nos. 5,890,281 and 7,220,135.

In more recent years, surface-mount packages and assembly techniques have dispensed with connection pins and simply rely on electrical connections provided on the housing and positioned on a printed circuit board. The electrical connections are subsequent soldered to circuit board contact pads to electrically connect and locate the surface-mount electronic devices on the circuit board.

One method used to locate devices with respect to a surface uses guide pins. For example, U.S. Patent No. 5,978,229 describes guide pins positioned in the corners of a socket that mate with non-standard holes on a circuit board. A related method is used to stack and electrically connect integrated circuits. Each circuit has a projecting pins on the bottom and receiving holes on the top, as disclosed in U.S. Patent Nos. 7,880,291 and 6,476,476.

These prior-art techniques do not always provide the precision needed for locating electronic devices, such as sensors, in the three-dimensional space within an electronic system. Furthermore, prior-art techniques do not provide accurate z-axis location (orthogonal to the typical x and y dimensions defining the surface of a printed circuit board) and are not necessarily suitable for systems in which the electronic devices are not disposed on a printed circuit board.

There is a need, therefore, for alternative positioning methods and structures for electronic devices within electronic systems.

### SUMMARY OF THE INVENTION

It is an aim of the present invention to provide a component which can be accurately positioned, and to provide a component assembly comprising said component, and a method of making said component assembly.

Embodiments of the present invention provide components, assemblies, and methods for simply and accurately positioning and electrically connecting devices on a support.

In some embodiments, a component comprises a housing, a circuit disposed in the housing, one or more leads each having an exterior portion extending from the housing, and at least two alignment holes. The alignment holes are disposed in the exterior portion of one or more of the leads and each alignment hole is configured to receive a positioning pin, for example a positioning pin disposed or formed on a support.

In some configurations, one or more of the leads are connected leads electrically connected to the circuit in the housing and an alignment hole is disposed in one or more of the connected leads. In some configurations, one or more of the leads are disconnected leads electrically separated from the circuit in the housing and an alignment hole is disposed in one or more of the disconnected leads. In some embodiments, one or more of the leads are test leads.

In some embodiments, two or more leads each comprise an alignment hole disposed in the exterior portion of each lead. In other embodiments, a lead comprises two or more alignment holes disposed in the exterior portion of the lead.

In various embodiments of the present invention, different exterior portions of a single lead have different widths and the exterior portion of the single lead can have an average width. In some embodiments, a lead has an average width and the width of the lead at the location of the alignment hole is larger than the average width. In some embodiments, the lead has an average width and the width of the exterior portion of the lead adjacent to the housing is smaller than the average width.

In embodiments, one or more of the leads is a first lead and one or more other leads are second leads. The exterior portion of the first lead extending from the housing is longer than the exterior portion of the second lead extending from the housing. In some embodiments, the exterior portion of the longer first lead extending from the housing has an average width greater than the average width of the exterior portion of the shorter second lead extending from the housing. In some embodiments, only the longer first lead comprises an alignment hole. The shorter second leads can provide test points for the circuit.

The circuit can comprise one or more discrete passive or active components, for example a discrete passive component such as a resistor or a capacitor.

In embodiments of the present invention, a component assembly comprises a support having a receiving zone and one or more positioning pins disposed on or in and protruding from the support in the receiving zone. A component is disposed on or over the support (for example on or over a surface of the support) in the receiving zone with a positioning pin disposed within each of at least two alignment holes.

In some configurations, a portion of a positioning pin is disposed over an exterior portion of a lead that is not the alignment hole in the lead, for example by deforming (e.g., bending) the positioning pin over the lead after the positioning pin is disposed in the alignment hole. A deformed positioning pin can help to mechanically secure the component in a desired location with respect to the support in any one or all of the x, y, and z axes.

In some embodiments of the present invention, a wire is electrically connected to a lead. The wire can be formed on or in the support or can be separate from the support. The wire can be a cable.

One or more of the positioning pins can be electrically connected to the lead in whose alignment hole the positioning pin is disposed.

According to some embodiments of the present invention, a method of making a component assembly comprises providing a component with two or more alignment holes disposed in leads extending from a circuit housing, providing a support with a receiving zone and one or more positioning pins disposed on and protruding from the support in the receiving zone, and disposing the component on or over the support with each positioning pin located within a corresponding alignment hole of the component. In a further embodiment of the present invention, the positioning pin is deformed so that at least a portion of the positioning pin is located over an exterior portion of the lead that is not the alignment hole in the lead.

Embodiments of the present invention provide electronic devices with improved positioning in an inexpensive structure.

### BRIEF DESCRIPTION OF THE DRAWINGS

The foregoing and other objects, aspects, features, and advantages of the present disclosure will become more apparent and better understood by referring to the following description taken in conjunction with the accompanying drawings, in which:
Fig. 1A is a perspective view of illustrative embodiments of the present invention;
Fig. 1B is a top view of illustrative embodiments of the present invention corresponding to Fig. 1A;
Fig. 1C is a top and side views of illustrative embodiments of the present invention corresponding to Fig. 1A;
Fig. 2 is a perspective view of illustrative embodiments of the present invention having a component with three leads, each comprising one alignment hole, disposed on a support with three corresponding positioning pins;
Fig. 3 is a perspective view of illustrative embodiments of the present invention having a component with one lead comprising two alignment holes and one lead with no alignment holes disposed on a support with two positioning pins disposed within the two alignment holes;
Fig. 4A is a perspective view according to illustrative embodiments of the present invention comprising a support with positioning pins and wires;
Fig. 4B is a schematic side view according to illustrative embodiments of the present invention comprising a support with positioning pins and electrically connecting wire cables;
Fig. 5 is a schematic side view according to illustrative embodiments of the present invention comprising positioning pins providing z-axis location;
Fig. 6 is a schematic side view according to illustrative embodiments of the present invention comprising bent positioning pins;
Fig. 7 is a schematic side view according to illustrative embodiments of the present invention comprising deformed positioning pins; and
Fig. 8 is a flow diagram of illustrative methods of the present invention.
Fig. 9 shows another exemplary embodiments of the present invention, wherein one of the leads has transverse protrusions so as to form a cross.

The features and advantages of the present disclosure will become more apparent from the detailed description set forth below when taken in conjunction with the drawings, in which like reference characters identify corresponding elements throughout. In the drawings, like reference numbers generally indicate identical, functionally similar, and/or structurally similar elements. The figures are not drawn to scale since the variation in size of various elements in the Figures is too great to permit depiction to scale.

### DETAILED DESCRIPTION OF THE INVENTION

Electronics manufacturing processes typically pick-and-place electronic components, such as integrated circuits, onto a substrate such as a printed-circuit board or into a test fixture. However, such placement processes have a limited positional accuracy and the actual position of the integrated circuit on the printed circuit board or in the test fixture can vary somewhat. Embodiments of the present invention can provide improved positioning of electronic devices in low-cost structures that are easy to make and adapt to a wide variety of circumstances and that provide simple electrical connections to the electronic device.

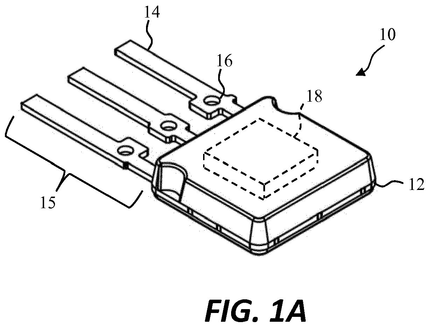

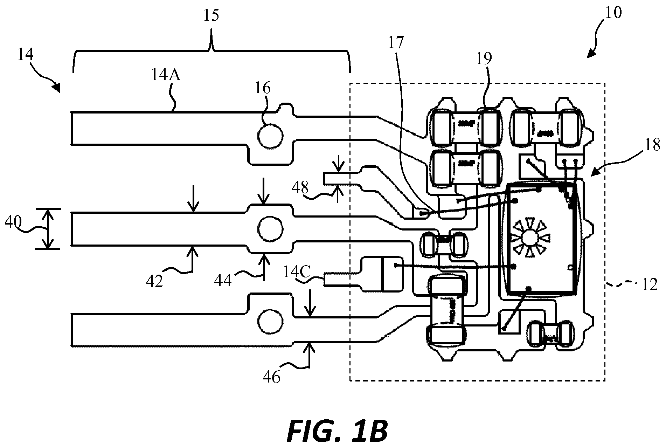

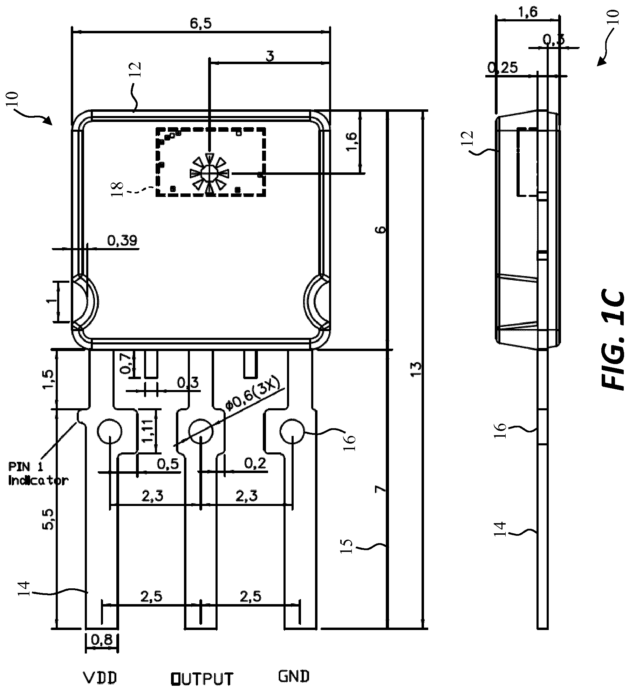

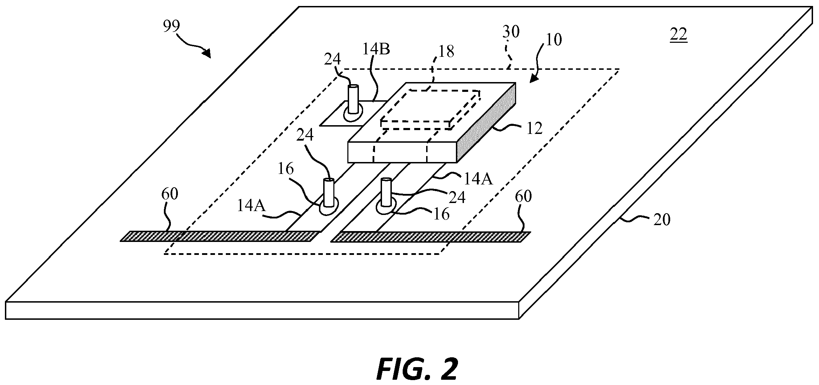

Referring to Fig. 1A in perspective, Fig. 1B in a top view, and Fig. 1C as top and side views of a design drawing, in some embodiments of the present invention a component 10 comprises a housing 12, a circuit 18 disposed in the housing 12, one or more leads 14 each having an exterior portion 15 extending from the housing 12, and at least two alignment holes 16. Each alignment hole 16 is disposed in the exterior portion 15 of one of the leads 14 and is configured to receive a positioning pin 24 (shown in Figs. 2-7).

Circuit 18 can be an electronic circuit, for example an integrated circuit, disposed in the housing and electrically connected with wire bonds to an interior portion of the leads 14 located inside the housing 12. Circuit 18 can be an analog circuit, a digital circuit, or a mixed signal circuit and can include both integrated and discrete components, 10 for example including a discrete passive component 19 such as a resistor or a capacitor (shown in Fig. 1B). Circuit 18 can be a sensor such as a magnetic sensor or position sensor. The response provided by such magnetic or position sensors can be very dependent on the location of the sensor and the location of the circuit 18 is important to the proper functioning of the component 10. Moreover, fixing the position of the leads 14 provides improved positioning accuracy compared to prior-art techniques of locating the housing or package of an integrated circuit, for example for a molded package or housing.

Housing 12 can serve as a body of the component 10 that has a cavity in which a semiconductor substrate and any discrete components are disposed and electrically connected. The semiconductor substrate can comprise an integrated circuit die formed in, on, or as a part of the semiconductor substrate. The integrated circuit die can be electrically connected with wire bonds 17 connecting contacts on the integrated circuit die to the interior portion of the leads 14 and any discrete components in the circuit 18. Housing 12 can be, for example, a ceramic or plastic package, as is known in the integrated circuit industry.

Leads 14 are also referred to as pins or connection pins and can serve as electrical connections to the circuit 18. Leads 14 can be electrically conductive and can comprise metal or a metal alloy, for example comprising copper, aluminum, tin, silver, gold or other metals and can be formed into a variety of shapes for example by stamping or die cutting or other metal-forming methods known in the art. Similarly, alignment holes 16 in leads 14 can be formed by stamping, die cutting, molding or other known methods. Leads 14 can be coated or layered. Leads 14 can have different lengths, shapes, and can be connected to different elements of the component 10, or none at all, for example different contact pads of circuit 18.

For example, in some embodiments of the present invention, one or more of the leads 14 are connected leads 14A electrically connected to the circuit 18 and an alignment hole 16 is disposed in one or more of the connected leads 14A (shown in Fig. 1B). In other embodiments, one or more of the leads 14 are disconnected leads 14B that are not electrically connected to the circuit 18 and an alignment hole 16 is disposed in one or more of the disconnected leads 14B (for example as shown in Fig. 2).

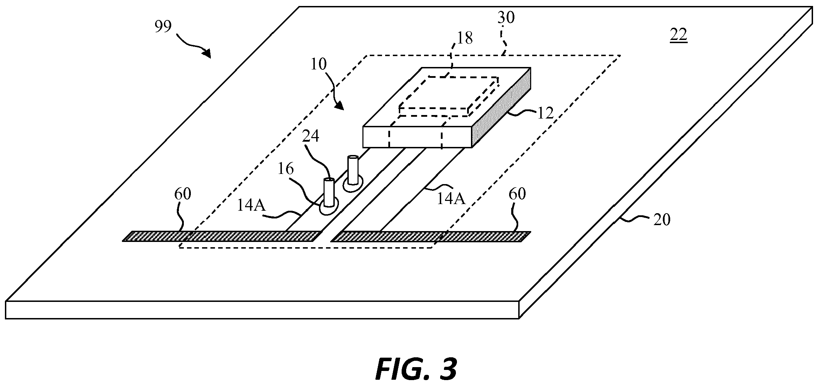

In some embodiments, the component 10 comprises two or more leads 14 and at least two of the two or more leads 14 each comprises a single alignment hole 16 disposed in the exterior portion 15 of the lead 14, for example as shown in Figs. 1A-1C and Fig. 2. In some embodiments, a lead 14 can comprise multiple alignment holes 16. For example, Fig. 3 illustrates an embodiment in which one connected lead 14A has two alignment holes 16 and one connected lead 14A has no alignment holes 16. In other embodiments, a component 10 can have any combination of connected or disconnected leads 14A, 14B each with no alignment holes 16, one alignment hole 16, or two or more alignment holes 16. The embodiment of Fig. 1B illustrates three connected leads 14A each with one alignment hole 16.

In various embodiments of the present invention and referring to Figs. 1A and 1B, the leads 14 have different lengths, width, or thicknesses. For example, an exterior portion 15 of a lead 14 can have an average width 40, a first width 42 at the distal end of the lead 14, a second width 44 at the location of the alignment hole 16, and a third width 46 at the proximal end of the exterior portion 15 of a lead 14. Any combination of the first, second, and third widths 42, 44, 46 can be different or the same. According to some embodiments of the present invention, an exterior portion 15 of a lead 14 has an average width 40 and the width 44 of the lead 14 at the location of the alignment hole 16 is greater than the average width 40. In some embodiments, the width 46 of the exterior portion 15 of the lead 14 adjacent to the housing 12 is less than the average width 40. By increasing the width of the lead 14 at the location of the alignment hole 16, the average width of the lead 14 can be decreased, saving space and materials while providing a robust mechanical structure.

In some embodiments of the present invention, leads 14 comprise first and second leads 14 and the exterior portion 15 of the first lead 14 extending from the housing 12 is longer than the exterior portion 15 of the second lead 14 extending from the housing 12. As shown in Figs. 1B and 1C, the shorter second leads 14C have a fourth width 48 that is different from and smaller than the first, second, and third widths 42, 44, 46. Moreover, in some embodiments and as illustrated, the shorter second leads 14C do not have alignment holes 16. In some such embodiments, the exterior portion 15 of the longer first leads 14 extending from the housing 12 has an average width 40 greater than the average width 48 of the exterior portion 15 of the shorter second leads 14C extending from the housing 12. In some designs the short leads 14C provide test connections for the component 10 without greatly increasing the size of the component 10 or the spacing of the leads 14.

Referring to Figs. 2 and 3, a component assembly 99 of the present invention can comprise a support 20. The support 20 can have a surface 22 with a receiving zone 30 in which components 10 are disposed, for example by pick-and-place equipment. One or more positioning pins 24 are disposed on and protrude from the support 20 in the receiving zone 30. A component 10 is disposed on or over the surface 22 of the support 20 within the receiving zone 30. A positioning pin 24 can be disposed within one alignment hole 16 of a lead 14, a positioning pin 24 can be disposed within each of two or more alignment holes 16, a positioning pin 24 can be disposed within each alignment hole 16, or every positioning pin 24 can be disposed within an alignment hole 16. As shown in Fig. 2, the component 10 can have both connected leads 14A electrically connected to the circuit 18 and disconnected leads 14B that are not electrically connected to the circuit 18. (Connected leads 14A and disconnected leads 14B are collectively referred to as leads 14.) Both connected leads 14A and disconnected leads 14B each have an alignment hole 16 with a positioning pin 24 disposed in the alignment holes 16. A positioning pin 24 can be, but is not necessarily, electrically conductive and can be electrically connected to a lead 14. Referring to Fig. 3, the component 10 can have connected leads 14A electrically connected to the circuit 18, some of which have more than one alignment hole 16 and some of which do not have any alignment holes 16.

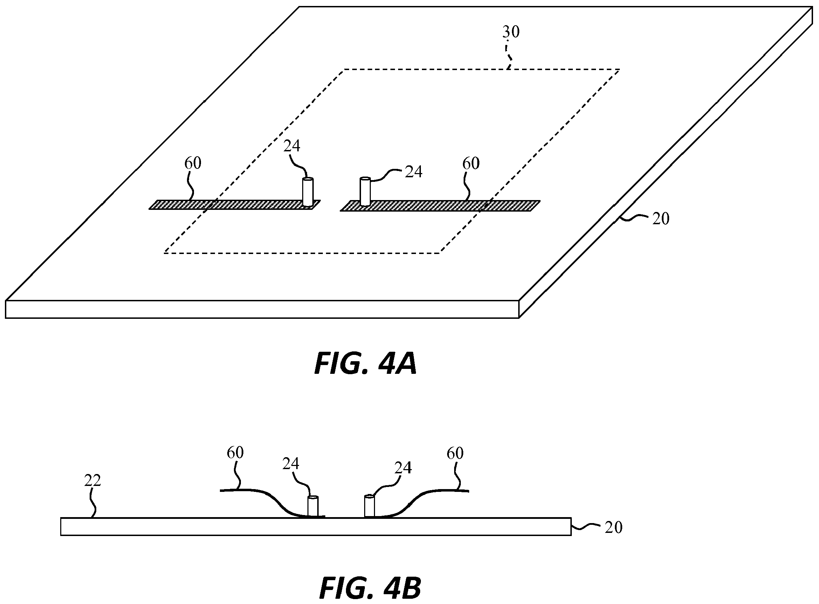

A support 20 can be planar (as shown in Figs. 2 and 3) or non-planar (not shown). A support 20 can have wires 60 integrated into the support 20 to form, for example, a printed circuit board or other wiring board or wires 60 can be provided separately from the support 20. A wire 60 can be electrically connected to each connected lead 14A. Referring to Fig. 4A, wires 60 can be directly connected, mechanically or electrically, to the positioning pins 24 or leads 14, or both. Referring to Fig. 4B, wires 60 can be provided independently of the support 20, for example as cables that are electrically connected to leads 14 directly (as shown) or indirectly (not shown). In some embodiments, the cable wires 60 can be directly connected to the positioning pins 24.

In various embodiments, the support 20 can comprise a resin or epoxy substrate, a multi-layer structure, for example planar structures, a cast, molded, or machined part or structure, for example comprising a polymer, metal, metal alloy, or ceramic. Likewise, the positioning pins 24 can be cast, molded, or machined, or formed by etching a part or structure. The positioning pins 24 can be electrically conductive or electrically insulating, and can comprise a polymer, metal, metal alloy, or ceramic. The positioning pins 24 can be rigid, flexible, compliant, or ductile. A positioning pin 24 can be electrically connected to each of, any one of, or none of the leads 14 and the wires 60.

According to embodiments of the present invention, the positioning pins 24 disposed in the alignment holes 16, for example by locating components 10 on the receiving zone 30 on or over the surface 22 of the support 20 with the positioning pins 24 disposed in the alignment holes 16 by pick-and-place equipment, serve to precisely locate the component 10 with respect to the support 20 in a simple and inexpensive way that can be applied to a broad variety of component assembly structures. By requiring two positioning pins 24 in alignment holes 16, the component 10 is spatially fixed in position with respect to the support 20 so that component 10 cannot rotate or move with respect to the support 20. By providing alignment holes 16 in the leads 14, additional alignment or mounting structures are rendered unnecessary, for example special housing 18 and support 20 structures, so that the components 10 can be smaller and take up less area of the support 20.

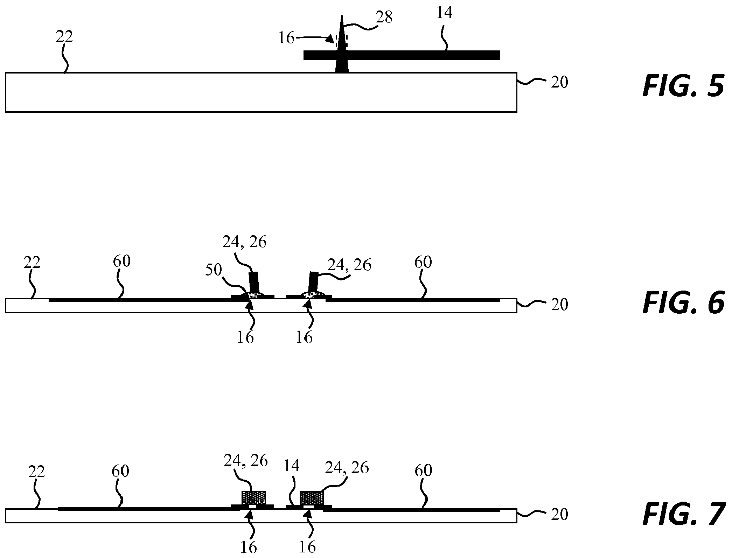

Referring to Fig. 5, in an embodiment the location of the component 10 is controlled in the z-axis (controlled with respect to the distance between the surface 22 of the support 20 and the component 10). The height of the component 10 with respect to the support 20 can be controlled with a positioning pin 24, for example by providing a variable diameter positioning pin 28 with a variable diameter that can accept an alignment hole 16 at only certain z-axis locations or heights above the support 20. The variable diameter can be continuous, as shown, or discontinuous, for example with stepped structures (not shown). In the case where circuit 18 is a sensor, the precise location of the sensor and any discrete passive components 19 can be important to the proper functioning of the sensor.

In some embodiments of the present invention, after the component 10 is disposed with positioning pins 24 in alignment holes 16, the positioning pin 24 can be deformed so that a portion of the positioning pin 24 is disposed over an electrically conductive exterior portion 15 of the lead 14 that is not the alignment hole 16 in the lead 14. For example, as shown in Fig. 6, the positioning pin 24 is deformed by bending the positioning pin 24 so that a portion of the bent deformed positioning pin 26 is located over a non-alignment-hole portion of the lead 14, that is over a conductive portion of the lead 14, such as a metallic portion and is not only over the alignment hole 16. As shown in Fig. 7, the positioning pin 24 is deformed by flattening the positioning pin 24 so that a portion of the flattened deformed positioning pin 26 is located over a non-alignment-hole portion of the lead 14. Positioning pins 24 can be mechanically deformed, for example by striking the positioning pin 24 with a hammer on the side of the positioning pin 24 to bend it or on the top of the positioning pin 24 to flatten it. By deforming a positioning pin 24 within an alignment hole 16 of a lead 14, a component 10 is held in place and is not readily removed from the positioning pin 24 and support 20.

In other or additional embodiments of the present invention, the wire 60, positioning pin 24 and lead 14 can be soldered together with solder 50 to form an electrical connection electrically connecting the circuit 18 to the wires 60 and the positioning pin 24 through the lead 14, if the lead 14 is a connected, electrically conductive lead 14A and the positioning pin 24 is electrically conductive, so that the positioning pin 24 is electrically connected to the lead 14 in whose alignment hole 16 the positioning pin 24 is disposed.

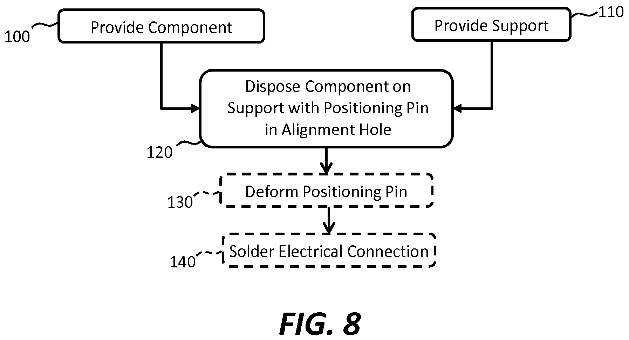

Referring to Fig. 8, a component assembly 99 of the present invention can be constructed by providing a component 10 as described above in step 100, for example using photolithographic methods to form a circuit 18, for example comprising an integrated circuit (IC) and discrete passive or active circuit elements, assembling the IC and circuit elements onto a substrate, for example a semiconductor, glass, or ceramic substrate, and interconnecting them with any combination of wire bond or photolithographic methods and tools to form an assembled circuit 18. Leads 14 are constructed using metal forming methods and integrated into a housing 12 with a cavity into which the assembled circuit 18 is disposed and electrically connected to the interior portion of the leads 14 inside the housing 12 using, for example, wire bonding methods. The housing 12 is then enclosed and encapsulated as desired.

A support 20 with one or more protruding positioning pins 24 is provided in step 110, for example by molding or laminating layers of resin or casting, molding, or machining materials such as ceramics, metals, or metal alloys into a desired shape, the shape providing a surface 22 with positioning pins 24 protruding from a surface 22 of the support 20 within a pre-determined receiving zone 30 for locating a component 10.

In step 120, a component 10 is disposed on a support 20 so that the alignment hole 16 of the component 10 is aligned with a positioning pin 24 and the positioning pin 24 is inserted into the alignment hole 16, for example using pick-and-place equipment from a tape-and-reel package.

Once the component 10 is properly disposed in the receiving zone 30 of the support 20, in optional step 130 the positioning pin 24 can be optionally deformed to firmly, rigidly, or irreversibly hold the component 10 in position with respect to the support 20. Multiple positioning pins 24 can be bent in different directions or deformed to widen the position pins 24, thus preventing each lead 14 from escaping the corresponding positioning pin 24. The deformation can locate at least a portion of the positioning pin 24 over an exterior portion 15 of the lead 14 that is not the alignment hole 16 in the lead 14. The deformation can provide mechanical robustness to the component assembly 99 and prevent the differential movement of the component 10 and the support 20, for example as a result of vibration.

In optional step 140, the positioning pin 24 can be optionally soldered to the lead 14, for example to provide an electrical connection between the lead 14 and the wire 60, and optionally the positioning pin 24. The solder 50 can also provide additional mechanical strength to the physical connection between the component 10 and the support 20.

In operation, power is provided to a wire 60 and thence to a lead 14 and circuit 18. Signals from the circuit 18 are sent through another lead 14 and wire 60 to a controller (not shown in the figures).

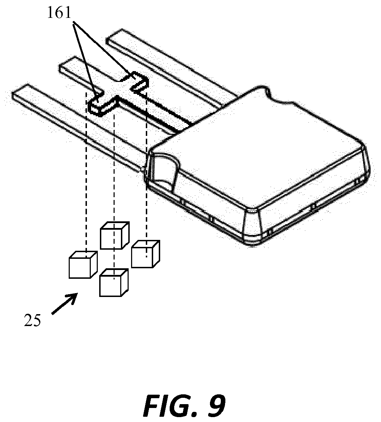

Fig. 9 shows another exemplary embodiments of the present invention, wherein one of the leads has transverse protrusions 161, which in the example form a cross, but that is not absolutely required. The leads can be inserted into a complementary cavity formed by three or by four blocks 25 protruding from a support surface. The blocks may be formed by a metal or a metal alloy or a plastic material. Optionally an additional metal or plastic cover element (not shown) is added on top of the blocks, and fixed thereto in any known manner, for example by soldering or by glueing. The lead 14 including the transverse protrusions 161 has a larger width than the average width 40.

As is understood by those skilled in the art, the terms "over", "under", "above", "below", "beneath", and "on" are relative terms and can be interchanged in reference to different orientations of the layers, elements, and substrates included in the present invention. For example, a first layer, element, or structure on a second layer, element, or structure in some embodiments means a first layer, element, or structure directly on and in contact with a second layer, element, or structure. In other embodiments, a first layer, element, or element on a second layer, element, or structure can include another layer there between. Additionally, "on" can mean "on" or "in" or "in contact with" or "directly on."

Having described certain embodiments, it will now become apparent to one of skill in the art that other embodiments incorporating the concepts of the disclosure may be used. Therefore, the invention should not be limited to the described embodiments, but rather should be limited only by the spirit and scope of the following claims.

Throughout the description, where apparatus and systems are described as having, including, or comprising specific elements, or where processes and methods are described as having, including, or comprising specific steps, it is contemplated that, additionally, there are apparatus, and systems of the disclosed technology that consist essentially of, or consist of, the recited elements, and that there are processes and methods according to the disclosed technology that consist essentially of, or consist of, the recited processing steps.

It should be understood that the order of steps or order for performing certain action is immaterial so long as the disclosed technology remains operable. Moreover, two or more steps or actions in some circumstances can be conducted simultaneously. The invention has been described in detail with particular reference to certain embodiments thereof, but it will be understood that variations and modifications can be effected within the spirit and scope of the invention.

### PARTS LIST

- 10: component
- 12: body / housing
- 14: pin / lead
- 14A: connected lead / first lead / long lead
- 14B: disconnected lead
- 14C: shorter second lead
- 15: exterior portion of lead
- 16: alignment hole
- 161: alignment protrusion
- 17: wire bond
- 18: circuit
- 19: discrete passive component
- 20: support
- 22: surface
- 24: positioning pin
- 26: deformed positioning pin
- 28: variable diameter positioning pin
- 30: receiving zone
- 40: average width
- 42: width / first width
- 44: width / second width
- 46: width / third width
- 48: width / fourth width / average width
- 50: solder
- 60: wire
- 99: component assembly
- 100: provide component step
- 110: provide support step
- 120: dispose component on support with positioning pin in alignment hole step
- 130: optional deform positioning pin step
- 140: optional solder electrical connection step

## Claims

1. A component (10), comprising:
a housing (12);
a circuit (18) disposed in the housing;
one or more leads (14) each having an exterior portion (15) extending from the housing (12); and
at least two alignment holes (16), wherein the alignment holes are disposed in the exterior portion (15) of one or more of the one or more leads (14), each alignment hole (16) configured to receive a positioning pin (24); and/or
the one or more leads (14) having at least two alignment protrusions (161) extending transversely from said one or more leads (14).

2. The component (10) of claim 1, wherein one or more of the one or more leads (14) are connected leads electrically connected to the circuit (18) and an alignment hole (16) is disposed in one or more of the connected leads.

3. The component (10) of claim 1 or 2, wherein the one or more leads comprises two or more leads (14), and wherein at least two of the two or more leads comprise an alignment hole (16) disposed in the exterior portion (15) of the lead (14).

4. The component (10) according to any of the previous claims, wherein the circuit (18) comprises at least one discrete passive component.

5. The component (10) according to any of the previous claims, wherein the one or more leads (14) has an average width, and a width of the one or more leads (14) at the location of the alignment hole (16) is greater than the average width.

6. The component (10) according to any of the previous claims, wherein the one or more leads (14) has an average width, and a width of the exterior portion (15) of the lead (14) adjacent to the housing is less than the average width.

7. The component (10) according to any of the previous claims, wherein the one or more leads (14) comprises first and second leads, and wherein the exterior portion (15) of the first lead extending from the housing (12) is longer than the exterior portion (15) of the second lead extending from the housing (12).

8. The component (10) of claim 7, wherein the exterior portion (15) of the longer, first lead extending from the housing (12) has an average width greater than the average width of the exterior portion (15) of the shorter, second lead extending from the housing (12), or wherein only the first lead comprises an alignment hole (16).

9. A component assembly (99), comprising:
a support (20) having a receiving zone (30), one or more positioning pins (24) disposed on and protruding from the support (20) in the receiving zone (30); and
a component (10) according to any of the previous claims, disposed on or over the support (20) within the receiving zone (30),
wherein a respective positioning pin (24) is disposed within each of at least two alignment holes (16).

10. The component assembly (99) of claim 9, wherein a portion of the positioning pin (24) is disposed over an exterior portion (15) of the lead that is not the alignment hole (16) in the lead.

11. The component assembly (99) of claim 9 or 10, comprising a wire (60) electrically connected to a lead (14).

12. The component assembly (99) of claim 9, comprising two or more leads (14) and wherein at least two of the two or more leads each comprise an alignment hole (16).

13. The component assembly (99) of claim 9, wherein one or more of the positioning pins (24) is electrically connected to the lead (14) in whose alignment hole (16) the positioning pin (24) is disposed.

14. A method of making a component assembly (99), comprising:
- providing a component (10) according to any of the claims 1 to 8;
- providing a support (20) with a receiving zone (30) and one or more positioning pins (24) disposed on and protruding from the support (20) in the receiving zone (30); and
- disposing the component (10) on or over the support (20) with the positioning pin (24) located within the alignment hole (16) of the component (10).

15. The method of claim 14, comprising:
- deforming the positioning pin (24) so that at least a portion of the positioning pin (24) is located over an exterior portion (15) of the lead (14) outside the alignment hole (16) in the lead (14).
